# EUROPEAN PATENT APPLICATION

(11) **EP 4 350 738 A1**
(43) Date of publication of application: **10.04.2024**
(21) Application number: 22810952.6
(22) Date of filing: 17.03.2022
(51) Int. Cl.: H01L 21/02

(54) **METHOD FOR MANUFACTURING COMPOUND SEMICONDUCTOR JUNCTION SUBSTRATE, AND COMPOUND SEMICONDUCTOR JUNCTION SUBSTRATE**

(30) Priority: 25.05.2021 JP 2021087550
(71) Applicant: Shin-Etsu Handotai Co., Ltd., Tokyo 100-0004 (JP)
(72) Inventor: ISHIZAKI, Junya, Annaka-shi, Gunma 379-0196 (JP); AKIYAMA ,Tomohiro, Annaka-shi, Gunma 379-0196 (JP)
(74) Representative: Sonnenhauser, Thomas Martin
(86) International application number: PCT/JP2022/012221
(87) International publication number: WO 2022/249675

(57) **Abstract**

The present invention relates to a method of manufacturing a compound semiconductor bonded substrate comprising the steps of:
(1) epitaxially growing a compound semiconductor functional layer on a starting substrate;
(2) temporarily bonding a support substrate to the epitaxially grown surface to form a first compound semiconductor bonded substrate;
(3) removing the starting substrate from the first compound semiconductor bonded substrate to form a second compound semiconductor bonded substrate;
(4) finally bonding a surface of the second compound semiconductor bonded substrate from which the starting substrate has been removed to a permanent substrate to form a third compound semiconductor bonded substrate;
(5) removing the support substrate from the third compound semiconductor bonded substrate to form a fourth compound semiconductor bonded substrate, wherein
the temporary bonding is performed via a thermosetting resin, the thermosetting resin being maintained in a softened state without being cured, and
the final bonding is performed via a silicon oxide film or a silicon nitride film.

Thus, provided is a method of manufacturing a compound semiconductor bonded substrate having an improved degree of freedom in designing a device or a device system.

## Description

### TECHNICAL FIELD

The present invention relates to a technique for epitaxially growing a compound semiconductor functional layer on a starting substrate, separating only the epitaxially grown layer, and transferring the epitaxially grown layer to another substrate.

### BACKGROUND ART

A technique to separate only an epitaxial functional layer from a starting substrate and transfer the layer to another substrate is an important technique to alleviate constraints caused by the physical properties of the starting substrate and improve a degree of freedom in designing a device system. Realizing a transfer requires a technique for realizing a transfer by bonding an epitaxial functional layer temporarily on a temporary support substrate and holding the layer, and then bonding the layer to a permanent substrate, and releasing the layer from the temporary bonding.

Patent Document 1 discloses a technique to separate a temporary support substrate and an epitaxial functional layer by wet etching. However, Document 1 needs separation grooves to separate the temporary support substrate and the epitaxial functional layer by wet etching.

Releasing by wet etching requires the formation of the separation grooves. Therefore, there are problems that the degree of freedom in the design has been constrained due to the existence of the separation grooves, for example, when non-uniform device patterns are on a single wafer or when the separation grooves need to be narrow.

### CITATION LIST

### PATENT LITERATURE

Patent Document 1: JP 2021-27301 A

### SUMMARY OF INVENTION

### TECHNICAL PROBLEM

The present invention has been made in view of the above-described problem. An object of the present invention is to provide a method of manufacturing a compound semiconductor bonded substrate that does not need separation grooves for separating an epitaxial functional layer from a support substrate, thereby having an improved degree of freedom in designing a device or a device system.

### SOLUTION TO PROBLEM

To achieve the object, the present invention provides a method of manufacturing a compound semiconductor bonded substrate comprising the steps of:
(1) epitaxially growing a compound semiconductor functional layer on a starting substrate;
(2) temporarily bonding a support substrate to the epitaxially grown surface to form a first compound semiconductor bonded substrate;
(3) removing the starting substrate from the first compound semiconductor bonded substrate to form a second compound semiconductor bonded substrate;
(4) finally bonding a surface of the second compound semiconductor bonded substrate from which the starting substrate has been removed to a permanent substrate to form a third compound semiconductor bonded substrate; and
(5) removing the support substrate from the third compound semiconductor bonded substrate to form a fourth compound semiconductor bonded substrate, wherein
   the temporary bonding in step (2) is performed via a thermosetting resin, the thermosetting resin being maintained in a softened state without being cured, and
   the final bonding in step (4) is performed via a silicon oxide film or a silicon nitride film.

In this way, the temporary bonding can be easily released by using a thermosetting resin and maintaining the thermosetting resin in a softened state without being cured, and the final bonding is performed via a silicon oxide film so that the thermosetting resin is not cured at a high temperature when the silicon oxide film is formed. Therefore, it is possible to improve a degree of freedom in designing a device or a device system.

Preferably, the thermosetting resin is applied to have a thickness of more than 1.0 µm and 30 µm or less.

It is preferable that the thickness is thicker than 1.0 um, which improves dissolving and release properties, and the thickness of 30 um or less is also preferable from the standpoints of cost and ensuring flatness after bonding.

Preferably, the thermosetting resin is a benzocyclobutene (BCB) resin, a fluororesin, or a polyimide (PI) resin.

These resins certainly maintain the softened state and achieve the dissolving and releasing with ease.

It is also preferable that the silicon oxide film or the silicon nitride film has a surface roughness Ra of 1 nm or less.

Such surface roughness is preferable to achieve stable bonding.

Preferably, the support substrate comprises any of AlN, Al₂O₃, Cu, GaAs, GaN, GaP, InP, Si, SiC, and SiO₂.

In the present invention, such a support substrate can be used suitably.

The present invention provides a compound semiconductor bonded substrate in which a compound semiconductor functional layer is bonded with a support substrate via a thermosetting resin, wherein the thermosetting resin is bonded in a softened state.

With such a compound semiconductor substrate, it is possible to finally bond the compound semiconductor functional layer and easily release the support substrate.

Preferably, the thermosetting resin has a thickness of more than 1.0 µm and 30 µm or less.

It is preferable that the thickness is thicker than 1.0 um, which improves the dissolving and release properties, and the thickness of 30 um or less is also preferable from the standpoints of cost and ensuring flatness after bonding.

It is preferable that the thermosetting resin is a benzocyclobutene (BCB) resin, a fluororesin, or a polyimide (PI) resin.

These resins certainly maintain the softened state and achieve the dissolving and releasing properties with ease.

Preferably, a silicon oxide film or a silicon nitride film is formed on a surface of the compound semiconductor functional layer to which the support substrate is not bonded.

The silicon oxide film formed as such enables a permanent bonding easily.

It is preferable that the silicon oxide film or the silicon nitride film has a surface roughness Ra of 1 nm or less.

Such surface roughness is preferable to achieve a stable bonding.

It is also preferable that the support substrate comprises any of AlN, Al₂O₃, Cu, GaAs, GaN, GaP, InP, Si, SiC, and SiO₂.

The present invention can use such a support substrate suitably.

### ADVANTAGEOUS EFFECTS OF INVENTION

As described above, the present invention makes it possible to provide a method of manufacturing a compound semiconductor bonded substrate that does not need separation grooves for separating an epitaxial functional layer from a support substrate, thereby having an improved degree of freedom in designing a device or a device system.

### BRIEF DESCRIPTION OF DRAWINGS

FIG. 1 is a flowchart illustrating an example of a method of manufacturing a compound semiconductor bonded substrate of the present invention.
FIG. 2 is a schematic view of epitaxial growth of a compound semiconductor functional layer on a starting substrate in the first and second embodiments of the present invention.
FIG. 3 is a schematic view of a first compound semiconductor bonded substrate formed by temporary bonding of a support substrate via a BCB resin on a grown epitaxial layer in the first and the second embodiments of the present invention.
FIG. 4 is a schematic view of a second compound semiconductor bonded substrate formed by removing the starting substrate in the first and the second embodiments of the present invention.
FIG. 5 is a schematic view of a silicon oxide film formed on a surface where the starting substrate has been removed in the first and the second embodiments of the present invention.
FIG. 6 is a schematic view of a third compound semiconductor bonded substrate formed by final bonding a surface of a silicon oxide film with a permanent substrate in the first and the second embodiments of the present invention.
FIG. 7 is a schematic view of a fourth compound semiconductor bonded substrate formed by removing the support substrate in the first and the second embodiments of the present invention.
FIG. 8 is a graph showing a relation between the thickness of a silicon oxide (SiO₂) film and surface roughness (Ra).
FIG. 9 is a graph showing a relation between machining allowance and the surface roughness (Ra) when the silicon oxide (SiO₂₎ film is polished.
FIG. 10 is a graph showing a relation between the thickness of the silicon oxide (SiO₂) film and an exfoliation area ratio when immersed in a dissolving solution, by using the thickness of BCB resin as a parameter.

### DESCRIPTION OF EMBODIMENTS

As described above, a method of manufacturing a compound semiconductor bonded substrate that does not need separation grooves for separating an epitaxial functional layer from a support substrate, thereby having an improved degree of freedom in designing a device or a device system, has been desired.

The present inventors have earnestly studied and found out that a temporary bonding is performed via a thermosetting resin to maintain a softened state without being cured, and a final bonding is performed via a silicon oxide film, which allows the temporary boding and the final bonding to be performed without creating separation grooves, and allows the support substrate to be easily released. Thus, the present invention has been completed.

The present invention is a method of manufacturing a compound semiconductor bonded substrate comprising the steps of:
(1) epitaxially growing a compound semiconductor functional layer on a starting substrate;
(2) temporarily bonding a support substrate to the epitaxially grown surface to form a first compound semiconductor bonded substrate;
(3) removing the starting substrate from the first compound semiconductor bonded substrate to form a second compound semiconductor bonded substrate;
(4) finally bonding a surface of the second compound semiconductor bonded substrate from which the starting substrate has been removed to a permanent substrate to form a third compound semiconductor bonded substrate; and
(5) removing the support substrate from the third compound semiconductor bonded substrate to form a fourth compound semiconductor bonded substrate, wherein
   the temporary bonding in step (2) is performed via a thermosetting resin, the thermosetting resin being maintained in a softened state without being cured, and
   the final bonding in step (4) is performed via a silicon oxide film or a silicon nitride film.

### <Method of manufacturing compound semiconductor bonded substrate>

Hereinafter, embodiments of the inventive method for manufacturing compound semiconductor bonded substrate will be described in further detail with reference to the drawings. However, the present invention is not limited thereto.

### (First Embodiment)

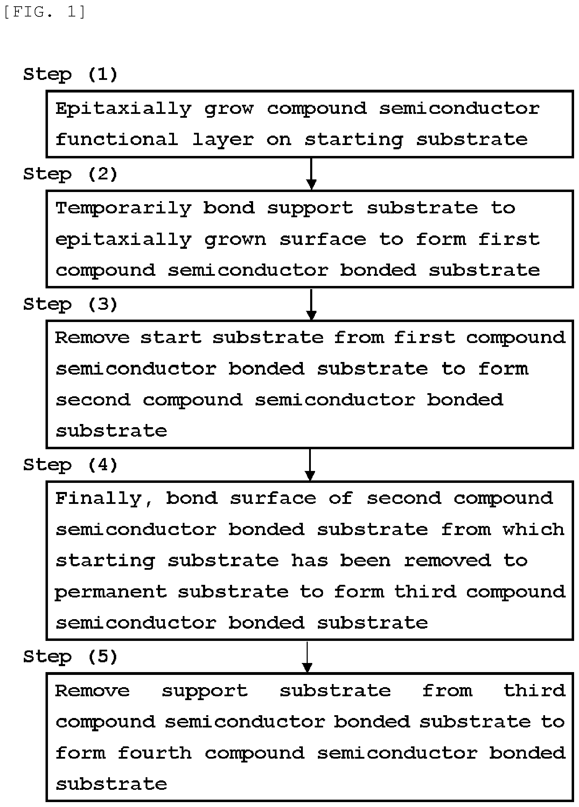

The first embodiment of the temporary bonding method for semiconductor substrates will be described with reference to FIGS. 1 to 7.

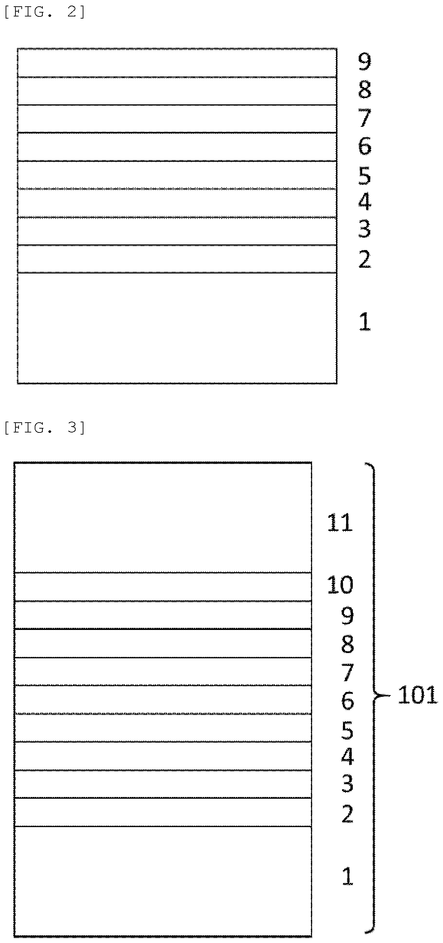

As shown in FIG. 2, the following are grown successively by using a MOCVD apparatus: a first conductivity type GaAs buffer layer 2 is stacked on a first conductivity type GaAs starting substrate 1; thereafter a first conductivity type GaInP first etch stop layer 3; a first conductivity type GaAs second etch stop layer 4; a first conductivity type AlGaInP first clad layer 5; a non-doped AlGaInP active layer 6; a second conductivity type AlGaInP second clad layer 7; a second conductivity type GaInP intermediate layer 8; and a second conductivity type GaP window layer 9. Thus, the epitaxial wafer has a light emitting device structure as an epitaxial functional layer (Step (1) in FIG. 1). Hereinafter, the stack from the first clad layer 5 to the second clad layer 7 will be referred to as a double hetero (DH) structure part.

Meanwhile, this structure is not limited to an AlGaInP-based light-emitting-diode structure, but an AlGaInP-based light-emitting-element structure in general, an AlGaAs-based light-emitting-element structure, an AlGaAs-based HEMT structure, an InGaP-based HBT structure, and an InGaP/GaAs-based solar cell structure that are lattice-matched to a GaAs substrate can obviously be applied as well. Also, applicable structures include an (Al)InGaAs(P)-based light-emitting-element structure, an (Al)InGaAs(P)-based light-receiving-element structure, (Al)InGaAs(P)-based HEMT structure, and an (Al)InGaAs(P)-based HBT structure that are lattice-matched to an InP substrate.

As shown in FIG. 3, a thermosetting resin, e.g., a benzocyclobutene (BCB) resin 10, is spin-coated on the epitaxial wafer, and the epitaxial wafer and the support substrate, e.g., a silicon wafer 11, are faced with each other, superimposed on each other, and thermo-compression bonded to each other. The epitaxial wafer and the silicon wafer 11 are bonded (temporally bonding) through the BCB resin 10 to form a first compound semiconductor bonded substrate 101 (Step (2) in FIG. 1). During bonding, the temperature of the BCB resin 10 should be kept to 150°C or less.

In addition, using a fluororesin or a polyimide (PI) resin as the thermosetting resin is also suitable. Applying the thermosetting resin to have a thickness of more than 1.0 um and 30 um or less is preferable. The thickness of more than 1.0 um improves the dissolving and release properties, and the thickness of 30 um or less reduces the cost and improves the flatness after bonding.

Moreover, the support substrate can include any of AlN, Al₂O₃, Cu, GaAs, GaN, GaP, InP, Si, SiC, and SiO₂.

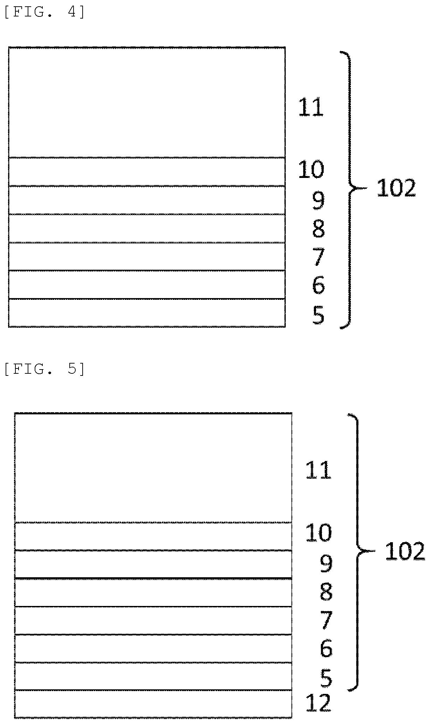

As shown in FIG. 4, to fabricate a second compound semiconductor bonded substrate 102 that only holds a DH layer and a window layer, the GaAs starting substrate 1 is removed by wet etching to expose the first etch stop layer 3, and the second etch stop layer 4 is removed with a switched etchant to expose the first clad layer 5 (Step (3) in FIG. 1). In this process, an ammonia hydrogen peroxide water-based etchant has an etching selectivity for GaInP-based materials and stops etching when it reaches the GaInP layer. Thereby, only the GaAs starting substrate can be selectively removed.

As shown in FIG. 5, a silicon oxide (SiO₂) film 12 is formed on the surface of the first clad layer 5 by a sputtering method with a thickness of 50 nm or less.

Although a SiO₂ film deposition by the sputtering method is exemplified in this embodiment, it is not limited to only the sputtering method as long as the temperature of over 150°C is not applied to the substrate and the manufacturing method can guarantee flatness. For example, such as a PLD (pulsed laser deposition) and an ALD (atomic layer deposition) are also selectable.

P-CVD can be used for film formation, but requires a heat application of higher than around 250°C. Because a BCB film cures even within a short period under a temperature condition of 250°C, an extremely short processing time is required to achieve a film deposition while suppressing curing of the BCB resin. Although the film deposition is possible, it can hardly be described as suitable.

Deposition with an electron gun also makes it possible to form the SiO₂ film while suppressing the rise in substrate temperature. When a film is formed by deposition with an electron gun, the film thickness has a wide distribution and an in-plane roughness distribution is also wide. Although the film deposition is possible, it can hardly be described as suitable.

Other than the bonding to a permanent substrate via SiO₂, it is possible that SiO₂ is not provided, a plasma activation treatment is performed, and then bonding to a permanent substrate is performed, for example. However, bonding with SiO₂ is adaptable to various process designs.

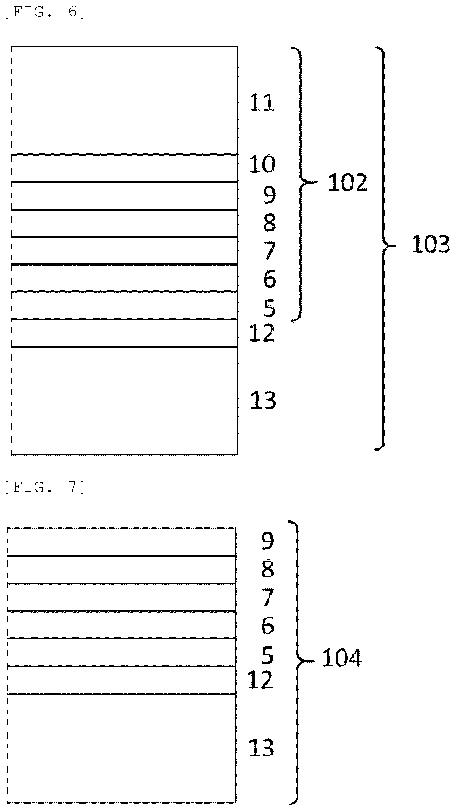

As shown in FIG. 6, both the surface of the silicon oxide (SiO₂) film 12 and the surface of the permanent substrate 13 (bonded wafer) are processed by a plasma activation treatment, overlapped in a vacuum atmosphere, and bonded (a final bonding) by applying a pressure to fabricate a third compound semiconductor bonded substrate 103 (Step (4) in FIG. 1).

Finally, as shown in FIG. 7, the third compound semiconductor bonded substrate 103 is immersed in a BCB dissolving solution to dissolve the BCB resin 10, and the silicon wafer 11 is separated from the third compound semiconductor bonded substrate 103 to make a fourth compound semiconductor bonded substrate 104.

When it is difficult for a releasing process of the silicon wafer 11 (the support substrate) to progress, the progress of the releasing can be facilitated by applying a rotational pressure on a side of the bonded silicon wafer 11.

Selecting the sputtering method for the formation of the silicon oxide (SiO₂) film and using a thin film condition of 2 nm or more and 50 nm or less enable the suppression of the temperature rise of the BCB resin film during the film deposition and achievement of the film deposition at 150°C or less. The BCB resin cures when it is held at a temperature condition of higher than 150°C. Therefore, the BCB resin is prevented from curing by holding the temperature of 150°C or less. Preventing the curing of the BCB resin improves the release property of the silicon wafer from the third compound semiconductor bonded substrate.

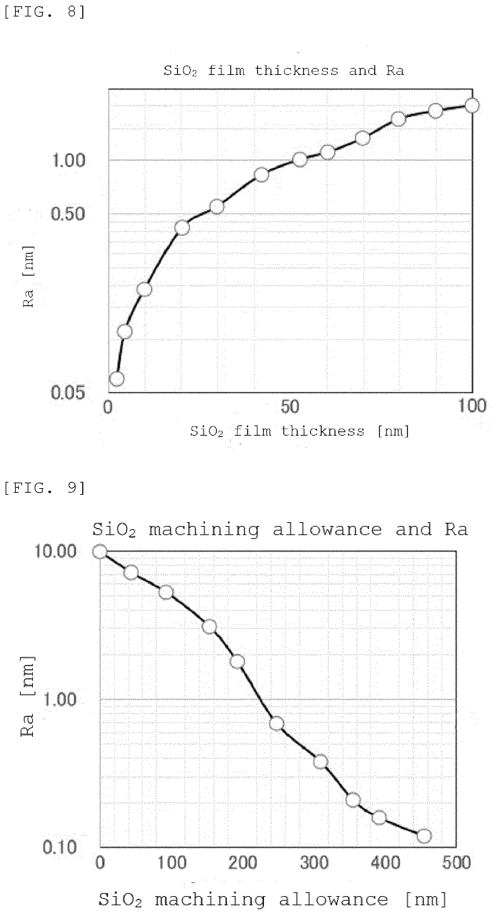

As shown in FIG. 8, when the thickness of the silicon oxide (SiO₂) film is 50 nm or less, the surface roughness (Ra) can be thinned to 1 nm or less. In the case of the bonding (final bonding) via a silicon oxide film (SiO₂), Ra is preferably 1 nm or less for more stable bonding. The lower-limit value of the surface roughness (Ra) has no limitation but can be 0 nm or more.

### (Second Embodiment)

The second embodiment of a temporary bonding method for semiconductor substrates will be described with reference to FIGS. 1 to 7.

As shown in FIG. 2, the following are grown successively by using a MOCVD apparatus: a first conductivity type GaAs buffer layer 2 is stacked on a first conductivity type GaAs starting substrate 1; thereafter a first conductivity type GaInP first etch stop layer 3; a first conductivity type GaAs second etch stop layer 4; a first conductivity type AlGaInP first clad layer 5; a non-doped AlGaInP active layer 6; a second conductivity type AlGaInP second clad layer 7; a second conductivity type GaInP intermediate layer 8; and a second conductivity type GaP window layer 9. Thus, the epitaxial wafer has a light emitting device structure as an epitaxial functional layer (Step (1) in FIG. 1). Hereinafter, a stack from the first clad layer 5 to the second clad layer 7 will be referred to as a double hetero (DH) structure part.

Meanwhile, this structure is not limited to an AlGaInP-based light-emitting-diode structure, but an AlGaInP-based light-emitting-element structure in general, an AlGaAs-based light-emitting-element structure, an AlGaAs-based HEMT structure, an InGaP-based HBT structure, and an InGaP/GaAs-based solar cell structure that are lattice-matched to a GaAs substrate can obviously be applied as well. Also, applicable structures include an (Al)InGaAs(P)-based light-emitting-element structure, and an (Al)InGaAs(P)-based light-receiving-element structure that are lattice-matched to an InP substrate.

As shown in FIG. 3, a thermosetting resin, e.g., a benzocyclobutene (BCB) resin 10, is spin-coated on the epitaxial wafer, and the epitaxial wafer and a silicon wafer 11 are faced with each other, superimposed on each other, and thermo-compression bonded to each other. The epitaxial wafer and the silicon wafer 11 are bonded (temporally bonding) through the BCB resin 10 to form a first compound semiconductor bonded substrate 101 (Step (2) in FIG. 1). During bonding, the temperature of the BCB resin 10 should be kept to 150°C or less.

Preferred concrete examples of the thermosetting resin and the support substrate are as described in the first embodiment.

As shown in FIG. 4, to fabricate a second compound semiconductor bonded substrate 102 that only holds a DH layer and a window layer, the GaAs starting substrate 1 is removed by wet etching to expose the first etch stop layer 3, and the second etch stop layer 4 is removed with a switched etchant to expose the first clad layer 5 (Step (3) in FIG. 1).

As shown in FIG. 5, a silicon oxide (SiO₂) film 12 is formed on the surface of the first clad layer 5 by a sputtering method with a film thickness of more than 50 nm and 5 um or less. Although it is possible to form the film with a thickness of up to 5 µm at one time, the film deposition at a time raises the temperature of the substrate and cures the BCB resin. Therefore, performing film deposition at one time should be about 2 to 3 µm and in case of depositing a thicker film, it is preferable to cool the substrate to prevent the substrate temperature from exceeding 100°C, followed by resuming deposition. This can suppress the temperature rise of the BCB film during the film deposition. The BCB resin cures when it is held at a temperature condition of higher than 150°C. Therefore, the BCB resin is prevented from curing by holding the temperature of 150°C or less. The prevention of the curing of the BCB resin makes it possible to ensure the release property of a silicon substrate from the permanent substrate.

The surface of the silicon oxide (SiO₂) film 12 is polished so that Ra is 1 nm or less by polishing. In the case of bonding via the silicon oxide (SiO₂) film, Ra = 1 nm or less is preferred for more stable bonding. FIG. 9 shows a relation between a machining allowance and the surface roughness (Ra) when the silicon oxide (SiO₂) film is polished. As shown in FIG. 9, Ra = 1 nm or less can be achieved with a machining allowance of 200 nm or more. Consequently, it is preferable that the polishing is performed with a machining allowance of 200 nm or more.

Additionally, processing by polishing to Ra of 0.1 nm or less improves the bonding yield after plasma activation treatment.

The embodiment exemplifies the SiO₂ film deposition by the sputtering method. However, it is obvious that the method is not limited to the sputtering method, as long as the manufacturing method does not apply temperatures exceeding 150°C to the substrate. For example, a pulsed laser deposition (PLD), an atomic layer deposition (ALD) and deposition with an electron gun are also selectable.

P-CVD can be used for film formation, but requires a heat application of higher than around 250°C. Because a BCB film cures even within a short period such as a few seconds under a temperature condition of 250°C, an extremely short processing time is required to achieve a film deposition while suppressing curing of the BCB resin. Although the film deposition is possible, it can hardly be described as suitable.

Other than the bonding to a permanent substrate via SiO₂, it is possible that SiO₂ is not provided, a plasma activation treatment is performed, and then bonding to a permanent substrate is performed, for example. However, bonding with SiO₂ is adaptable to various process designs.

As shown in FIG. 6, both the surface of the silicon oxide (SiO₂) film 12 and the surface of the permanent substrate 13 (bonded wafer) are processed by a plasma activation treatment, overlapped in a vacuum atmosphere, and bonded (a final bonding) by applying a pressure to fabricate a third compound semiconductor bonded substrate 103 (Step (4) in FIG. 1).

Finally, as shown in FIG. 7, the third compound semiconductor bonded substrate 103 is immersed in a BCB dissolving solution to dissolve the BCB resin 10, and the silicon wafer 11 is separated from the third compound semiconductor bonded substrate 103 to make a fourth compound semiconductor bonded substrate 104 (Step (5) in FIG. 1).

When it is difficult for a releasing process of the silicon wafer to progress, the progress of the releasing can be facilitated by applying a rotational pressure on a side of the bonded silicon wafer 11.

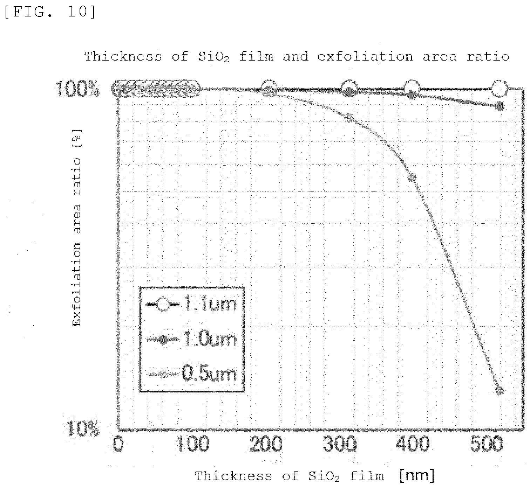

FIG. 10 shows a relation between the thickness of the silicon oxide (SiO₂) film and the exfoliation area ratio when immersed in a dissolving solution, using the thickness of BCB resin as a parameter. As shown in FIG. 10, if the BCB resin is thin (0.5 um), the exfoliation area ratio decreases as the thickness of the silicon oxide (SiO₂) film increases. Accordingly, it is preferable to make the thickness of the BCB resin greater than 1 µm. Considering cost and flatness, the upper limit is preferably 30 µm.

Selecting the sputtering method can suppress the temperature rising of the BCB layer compared with other film deposition methods such as P-CVD and achieve the film deposition at the temperature of 150°C or less. The curing of the BCB resin progresses in a temperature condition of more than 150°C, and thus maintaining the temperature of 150°C or less can prevent curing of the BCB resin. Prevention of the BCB resin curing enables the improvement of the release property of the silicon wafer from the third compound semiconductor bonded substrate.

### <Compound semiconductor bonded substrate>

The present invention provides a compound semiconductor bonded substrate in which a compound semiconductor functional layer is bonded with a support substrate via a thermosetting resin, wherein the thermosetting resin is bonded in a softened state.

Specific embodiments of the inventive compound semiconductor bonded substrate are shown in the first and second embodiments of the inventive method of manufacturing compound semiconductor bonded substrate described above. With such a compound semiconductor substrate, the compound semiconductor functional layer can be finally bonded and the support substrate can be easily released.

### EXAMPLE

Hereinafter, the present invention will be specifically described with reference to Examples and Comparative Examples. However, the present invention is not limited thereto.

### (Example 1)

The following were grown successively by using a MOCVD apparatus: 0.5 um of a first conductivity type GaAs buffer layer was stacked on a first conductivity type GaAs starting substrate; thereafter 0.1 um of a first conductivity type GaInP first etch stop layer; 0.1 um of a first conductivity type GaAs second etch stop layer; 1 um of a first conductivity type AlGaInP first clad layer; 0.5 um of a non-doped AlGaInP active layer; 1 um of a second conductivity type AlGaInP second clad layer; 0.1 um of a second conductivity type GaInP intermediate layer; and 3 um of a second conductivity type GaP window layer. Thus, the epitaxial wafer having a light emitting device structure as an epitaxial functional layer was produced (FIG. 2).

Then, a benzocyclobutene (BCB) resin was dropped on the epitaxial wafer, which was spin-coated at 5000 rpm, and 1 µm of a BCB film was formed on the epitaxial wafer. A silicon wafer was prepared as a support substrate, and the BCB film side of the epitaxial wafer and the polished side of the silicon wafer were superimposed, facing each other, and introduced into a bonding machine. Temporary bonding was performed by thermo-compression-bonding under a vacuum atmosphere to form a first compound semiconductor bonded substrate (FIG. 3).

Then, the BCB resin was kept at around 150°C to soften the BCB resin and the temperature was lowered for bonding.

Then, the first compound semiconductor bonded substrate was immersed in an ammonia hydrogen peroxide water-based etchant to remove the GaAs starting substrate by wet etching and form a second compound semiconductor bonded substrate. Subsequently, the first etch stop layer was removed using a hydrochloric acid-based etchant.

When the second etch stop layer was exposed, the GaAs second etch stop layer was removed by sulfuric acid/hydrogen peroxide mixture-based etchant. By performing the processes described above, the first clad layer was exposed, and the second compound semiconductor bonded substrate, holding only a DH layer and a window layer, was fabricated (FIG. 4).

Subsequently, SiO₂ was deposited on the surface of the first clad layer by a sputtering method at a temperature of 150°C or less with a film thickness of 50 nm or less (FIG. 5).

Next, both the surface of the SiO₂ film and the surface of the silicon wafer to be the permanent substrate were irradiated with nitrogen plasma in a vacuum to activate the surfaces. The surfaces were then superimposed and pressure was applied thereto for final bonding to fabricate a third compound semiconductor bonded substrate (FIG. 6).

Furthermore, the third compound semiconductor bonded substrate was immersed in a BCB dissolving solution (mesitylene) to dissolve the BCB resin. The silicon wafer, which was the support substrate, was separated from the third compound semiconductor bonded substrate to form a fourth compound semiconductor bonded substrate (FIG. 7).

### (Example 2)

The following were grown successively by using a MOCVD apparatus: 0.5 um of a first conductivity type GaAs buffer layer was stacked on a first conductivity type GaAs starting substrate; 0.1 um of a first conductivity type GaₓIn₁₋ₓP (0.4≤x≤0.6) first etch stop layer; 0.1 µm of a first conductivity type GaAs second etch stop layer; 1 um of a first conductivity type (Al_{y}Ga_{1-y})ₓIn₁₋ₓP (0.4≤x≤0.6,0.6≤y≤1) first clad layer; 0.5 µm of a non-doped AlGaInP active layer; 1 um of a second conductivity type AlGaInP second clad layer; 0.1 µm of a second conductivity type GaInP intermediate layer; 3 µm of a second conductivity type GaP window layer. Thus, the epitaxial wafer having a light emitting device structure as an epitaxial functional layer was produced (FIG. 2).

Then, a benzocyclobutene (BCB) resin was dropped on the epitaxial wafer, which was spin-coated at 5000 rpm, and 1 µm of a BCB film was formed on the epitaxial wafer. A silicon wafer was prepared as a support substrate, and the BCB film side of the EPW and the polished side of the silicon wafer were superimposed, facing each other, and introduced into a bonding machine. Temporary bonding was performed by thermo-compression-bonding under a vacuum atmosphere to form a first compound semiconductor bonded substrate (FIG. 3).

Then, the BCB resin was kept at around 150°C to soften the BCB resin and the temperature was lowered for bonding.

Then, the first compound semiconductor bonded substrate was immersed in an ammonia hydrogen peroxide water-based etchant to remove the GaAs starting substrate by wet etching and form a second compound semiconductor bonded substrate. Subsequently, the first etch stop layer was removed using a hydrochloric acid-based etchant.

When the second etch stop layer was exposed, the GaAs second etch stop layer was removed by sulfuric acid/hydrogen peroxide mixture-based etchant. By performing the processes described above, the first clad layer was exposed, and the second compound semiconductor bonded substrate, holding only a DH layer and a window layer, was fabricated (FIG. 4).

Subsequently, SiO₂ was deposited on the surface of the first clad layer by a sputtering method at a temperature of 150°C or less with a film thickness of 5 µm. Although it is possible to deposit a film up to 5 um at one time, such depositing at once raises the temperature of the bonding substrate and causes the BCB resin to be cured. As such, the deposition was limited to around 2 to 3 um at a time, and when depositing a thicker film, the substrate was cooled and the film was deposited again. After deposition, the SiO₂ surface was polished until the Ra of the SiO₂ surface was 0.1 nm or less. (FIG 5).

Next, both the surface of the SiO₂ film and the surface of the silicon wafer to be the permanent substrate were irradiated with nitrogen plasma in a vacuum to activate the surfaces. The surfaces were then superimposed and pressure was applied thereto for final bonding to fabricate a third compound semiconductor bonded substrate (FIG. 6).

Furthermore, the third compound semiconductor bonded substrate was immersed in a BCB dissolving solution (mesitylene) to dissolve the BCB resin. The silicon wafer, which was the support substrate, was separated from the third compound semiconductor bonded substrate to form a fourth compound semiconductor bonded substrate (FIG. 7).

As described above, the inventive method of manufacturing a compound semiconductor bonded substrate does not need the formation of separation grooves because a separation of a support substrate and an epitaxial function layer needs no wet etching.

In Comparative Example 1, described below, an additional BCB removal process is required after the removal of a support substrate, but such a process is unnecessary in Examples 1 and 2. Consequently, in the process of releasing the support substrate from a permanent substrate that mounts the support substrate, a plasma atmosphere (such as a dry etching atmosphere or an ashing atmosphere) is not required, and essentially no new damage is caused to the permanent substrate.

Similarly, BCB removal is performed by dissolving and releasing, and therefore, the releasing property is higher than that of laser ablation, and the yield after releasing can be higher than in Comparative Example 1. Additionally, since the laser process is unnecessary, there is no need for laser equipment, and the total cost, including amortization expense and operation cost, can be reduced to be less than the Comparative Example 1.

### (Comparative Example 1)

The following were grown successively by using a MOCVD apparatus: 0.5 um of a first conductivity type GaAs buffer layer was stacked on a first conductivity type GaAs starting substrate; 0.1 um of a first conductivity type GaₓIn₁₋ₓP (0.4≤x≤0.6) first etch stop layer; 0.1 um of a first conductivity type GaAs second etch stop layer; 1 um of a first conductivity type (Al_{y}Ga_{1-y})ₓIn₁₋ₓP (0.4≤x≤0.6,0.6≤y≤1) first clad layer; 0.5pm of a non-doped AlGaInP active layer; 1 um of a second conductivity type AlGaInP second clad layer; 0.1 um of a second conductivity type GaInP intermediate layer; 3 um of a second conductivity type GaP window layer. Thus, the epitaxial wafer having a light emitting device structure as an epitaxial functional layer was produced (FIG. 2).

Then, the BCB resin was dropped on the epitaxial wafer, which was spin-coated at 5000 rpm, and 1 µm of a BCB film was formed on the epitaxial wafer. A sapphire substrate was prepared as a support substrate, and the BCB film side of the epitaxial wafer and the polished side of the sapphire substrate were superimposed, facing each other, and introduced into a bonding machine. Temporary bonding was performed by thermo-compression-bonding under a vacuum atmosphere to form an EPW-bonded substrate.

When the epitaxial wafer bonded substrate was fabricated, the temperature of the BCB resin was kept at about 300°C to fully cure the BCB resin for strong bonding.

The epitaxial bonded substrate was immersed in an ammonia hydrogen peroxide water-based etchant to remove the GaAs starting substrate by wet etching, and then the first etch stop layer was removed using a hydrochloric acid-based etchant.

When the second etch stop layer was exposed, the GaAs second etch stop layer was removed by sulfuric acid/hydrogen peroxide mixture-based etchant. By performing the processes described above, the first clad layer was exposed, and the epitaxial bonded substrate, holding only a DH layer and a window layer, was fabricated.

The surface of the first clad layer was spin-coated with the BCB resin and bonded to the permanent substrate. Then, from the sapphire substrate side, irradiation with a short-pulse laser was performed, focusing on and concentrating light to the BCB layer in the temporary bonding region, and the BCB was demolished to form a release region to separate the sapphire substrate from the permanent substrate.

As just described, even if the BCB resin for the temporary bonding is fully cured, utilizing laser lift-off enables to separate the sapphire substrate from the permanent substrate without wet etching. However, the laser lift-off is an ablation process and in the process of ablation, the BCB resin cannot be completely evaporated, and the first clad layer is never fully exposed. BCB residue is inherently generated.

Although the dry etching removes the BCB residue with ease, the dry etching process needs to be performed after mounting, which causes damage to the mounting substrate. Removal by ashing to avoid damage caused by dry etching is not impossible, but the BCB removal effect by ashing is small and removal takes substantial time. Consequently, even if the plasma output is smaller than dry etching, there is a demerit to cause damage to the mounting substrate.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method of manufacturing a compound semiconductor bonded substrate comprising the steps of:
(1) epitaxially growing a compound semiconductor functional layer on a starting substrate;
(2) temporarily bonding a support substrate to the epitaxially grown surface to form a first compound semiconductor bonded substrate;
(3) removing the starting substrate from the first compound semiconductor bonded substrate to form a second compound semiconductor bonded substrate;
(4) finally bonding a surface of the second compound semiconductor bonded substrate from which the starting substrate has been removed to a permanent substrate to form a third compound semiconductor bonded substrate; and
(5) removing the support substrate from the third compound semiconductor bonded substrate to form a fourth compound semiconductor bonded substrate, wherein
the temporary bonding in step (2) is performed via a thermosetting resin, the thermosetting resin being maintained in a softened state without being cured, and
the final bonding in step (4) is performed via a silicon oxide film or a silicon nitride film.

2. The method of manufacturing a compound semiconductor bonded substrate according to claim 1, wherein
the thermosetting resin is applied to have a thickness of more than 1.0 µm and 30 µm or less.

3. The method of manufacturing a compound semiconductor bonded substrate according to claim 1 or 2, wherein
the thermosetting resin is a benzocyclobutene (BCB) resin, a fluororesin, or a polyimide (PI) resin.

4. The method of manufacturing a compound semiconductor bonded substrate according to any one of claims 1 to 3, wherein
the silicon oxide film or the silicon nitride film has a surface roughness Ra of 1 nm or less.

5. The method of manufacturing a compound semiconductor bonded substrate according to any one of claims 1 to 4, wherein
the support substrate comprises any of AlN, Al₂O₃, Cu, GaAs, GaN, GaP, InP, Si, SiC, and SiO₂.

6. A compound semiconductor bonded substrate in which a compound semiconductor functional layer is bonded with a support substrate via a thermosetting resin, wherein the thermosetting resin is bonded in a softened state.

7. The compound semiconductor bonded substrate according to claim 6, wherein
the thermosetting resin has a thickness of more than 1.0 µm and 30 µm or less.

8. The compound semiconductor bonded substrate according to claim 6 or 7, wherein
the thermosetting resin is a benzocyclobutene (BCB) resin, a fluororesin, or a polyimide (PI) resin.

9. The compound semiconductor bonded substrate according to any one of claims 6 to 8, wherein
a silicon oxide film or a silicon nitride film is formed on a surface of the compound semiconductor functional layer to which the support substrate is not bonded.

10. The compound semiconductor bonded substrate according to claim 9, wherein
the silicon oxide film or the silicon nitride film has a surface roughness Ra of 1 nm or less.

11. The compound semiconductor bonded substrate according to any one of claims 6 to 10, wherein
the support substrate comprises any of AlN, Al₂O₃, Cu, GaAs, GaN, GaP, InP, Si, SiC, and SiO₂.
